# EUROPEAN PATENT APPLICATION

(11) **EP 4 822 466 A1**
(43) Date of publication of application: **14.10.2026**
(21) Application number: 26171951.2
(22) Date of filing: 13.04.2026
(51) Int. Cl.: G05B 19/401

(54) **SYSTEM AND METHOD FOR MANUFACTURING AN AIRCRAFT ENGINE COMPONENT**

(30) Priority: 11.04.2025 US 202519176262
(71) Applicant: Pratt & Whitney Canada Corp., Longueuil, Québec J4G 1A1 (CA)
(72) Inventor: PANERO, Samuel, (01BE5) Longueuil, J4G 1A1 (CA); RAHMAN, MD Mizanur, (01BE5) Longueuil, J4G 1A1 (CA)
(74) Representative: Dehns

(57) **Abstract**

A method (300) for manufacturing a component of an aircraft engine (10) includes positioning two sub-components of the component in a fixture of a CNC machine, and performing, with a 3D scanner, a first scan of the two sub-components on the fixture. A predetermined tool pathway for combining the two sub-components is updated based on the first scan to establish a modified tool pathway for combining the two sub-components. A welding procedure is performed to combine the two sub-components based on the modified tool pathway to form the component. Using the 3D scanner, and with the component retained in place in the fixture, a second scan of the component is performed to identify the presence of one or more surface defects on the component. In response to identifying the presence of the surface defect(s), a corrective procedure is performed to correct the one or more surface defects on the component.

## Description

### TECHNICAL FIELD

The invention relates generally to manufacturing aircraft engine parts and, more particularly, to manufacturing of welded parts for aircraft engines.

### BACKGROUND

Certain parts of an aircraft engine, such as compressor vanes, require precise assembly and repair to ensure optimal performance. Traditional methods for assembling and repairing these components often involve manual processes, for instance for parts that are to be meticulously aligned and welded. While existing methods are suitable for their intended purposes, improvements are desired.

### SUMMARY

According to one aspect of the present invention, there is provided a method for manufacturing a component of an aircraft engine, comprising: positioning two sub-components of the component in a fixture of a computer numerical control (CNC) machine; performing, with a 3D scanner, a first scan of the two sub-components on the fixture; updating a predetermined tool pathway for combining the two sub-components based on the first scan to establish a modified tool pathway for combining the two sub-components; performing a welding procedure to combine the two sub-components based on the modified tool pathway to form the component; performing, with the 3D scanner and with the component retained in place in the fixture, a second scan of the component to identify the presence of one or more surface defects on the component; and in response to identifying the presence of the one or more surface defects, performing a corrective procedure to correct the one or more surface defects on the component.

In certain embodiments, the method as defined above and described herein also includes one or more of the following features, in whole or in part, and in any combination.

Optionally, and in accordance with the above, the component remains on the fixture, without removal, between the step of mounting the two sub-components to the fixture of the CNC machine and the step of performing the corrective procedure to correct the one or more surface defects on the component.

Optionally, and in accordance with any of the above, the method further includes, subsequent to the performing the corrective procedure, performing one or more finishing operations on the component.

Optionally, and in accordance with any of the above, the performing the welding procedure to combine the two sub-components includes performing a micro-welding procedure.

Optionally, and in accordance with any of the above, the 3D scanner is a topometric scanner and the performing the scan of the two sub-components on the fixture includes acquiring coordinates of position markers on the two sub-components.

Optionally, and in accordance with any of the above, the method includes performing a third scan of the component, and based on the third scan, determining and outputting an indication of acceptability of the component based on a predetermined acceptability criteria of the component.

Optionally, and in accordance with any of the above, the method includes, subsequent to the determining and outputting an acceptability of the component based on the predetermined acceptability criteria of the component, transferring data pertaining to the manufacturing of the component to a database of a machine learning model.

Optionally, and in accordance with any of the above, transferring data pertaining to the manufacturing of the component to the database of the machine learning model includes transferring data pertaining to one or more of trends in the welding procedure of the component and trends in the one or more surface defects on the component.

According to another aspect of the present invention, there is provided a system for manufacturing a component of an aircraft engine, comprising: a computer numerical control (CNC) machine tool having a fixture for retaining the component, a machining module selectively controllable to machine the component, and a coordinate measuring machine (CMM) module selectively controllable to perform a 3D scan of the component; and a controller in communication with the CNC machine tool, the controller including a processing unit; and non-transitory memory communicatively coupled to the processing unit and comprising computer-readable program instructions executable by the processing unit for: positioning two sub-components of the component in a fixture of a CNC computer numerical control (CNC) machine; performing, with a 3D scanner, a first scan of the two sub-components on the fixture; updating a predetermined tool pathway for combining the two sub-components based on the first scan to establish a modified tool pathway for combining the two sub-components; performing a welding procedure to combine the two sub-components based on the modified tool pathway to form the component; performing, with the 3D scanner and with the component retained in place in the fixture, a second scan of the component to identify the presence of one or more surface defects on the component; and in response to identifying the presence of the one or more surface defects, performing a corrective procedure to correct the one or more surface defects on the component.

In certain embodiments, the system as defined above and described herein also includes one or more of the following features, in whole or in part, and in any combination.

Optionally, and in accordance with the above, the component remains on the fixture, without removal, between the step of mounting the two sub-components to the fixture of the CNC machine and the step of performing a corrective procedure to correct the one or more surface defects on the component.

Optionally, and in accordance with any of the above, the system includes a finishing tool, and wherein the instructions are further executable by the processing unit for, subsequent to the performing the corrective procedure, performing one or more finishing operations on the component.

Optionally, and in accordance with any of the above, the performing the welding procedure to combine the two sub-components includes performing a micro-welding procedure.

Optionally, and in accordance with any of the above, the 3D scanner is a topometric scanner and the performing the scan of the two sub-components on the fixture includes acquiring coordinates of position markers on the two sub-components.

Optionally, and in accordance with any of the above, the non-transitory memory communicatively coupled to the processing unit and comprising computer-readable program instructions executable by the processing unit for: performing a third scan of the component; and based on the third scan, determining and outputting an indication of acceptability of the component based on a predetermined acceptability criteria of the component.

Optionally, and in accordance with any of the above, the instructions are further executable by the processing unit for, subsequent to the determining and outputting an acceptability of the component based on the predetermined acceptability criteria of the component, transferring data pertaining to the manufacturing of the component to a database of a machine learning model.

Optionally, and in accordance with any of the above, transferring data pertaining to the manufacturing of the component to the database of the machine learning model includes transferring data pertaining to one or more of trends in the welding procedure of the component and trends in the one or more surface defects on the component.

According to another aspect of the present invention there is provided a computer numerical control (CNC) machine tool assembly for manufacturing a component of an aircraft engine, comprising: a fixture for receiving two sub-components of the component; a machining module selectively controllable to perform: a welding procedure to produce the component from the two sub-components based on a tool pathway for the welding procedure; and a correction procedure to correct one or more identified defects of the component; and a coordinate measuring machine (CMM) module selectively controllable to perform: a first scan of the two sub-components in the fixture to modify a predetermined tool pathway for the welding procedure to establish an actual tool pathway for the welding procedure; a second scan of the component, subsequent to the welding of the two sub-components, to identify the one or more identified defects of the component to be corrected; and a third scan of the component to inform a judgment of an acceptability of the component based on a predetermined acceptability criteria of the component.

Optionally, and in accordance with the above, the CNC machine tool assembly as defined above and described herein also includes one or more of the following features, in whole or in part, and in any combination.

Optionally, and in accordance with any of the above, the machining module further includes a finishing tool and is further selectively controllable to perform, subsequent to correction procedure, one or more finishing operations on the component.

Optionally, and in accordance with any of the above, the fixture is adapted to retain the component on the fixture throughout the welding procedure and the correction procedure.

Optionally, and in accordance with any of the above, the assembly includes a machine learning module with a database adapted to receive data pertaining to the manufacturing of the component.

### BRIEF DESCRIPTION OF THE DRAWINGS

Reference is now made to the accompanying figures in which:
FIG. 1 is a schematic cross sectional view of a gas turbine engine;
FIG. 2 is a diagrammatic representation of a machine tool;
FIG. 3 is a flowchart illustrating steps of an exemplary method for manufacturing a component of an aircraft engine;
FIG. 4 is flowchart illustrating steps of an exemplary adaptive welding subprocess for the method of FIG. 3;
FIG. 5 is flowchart illustrating steps of an exemplary part analysis and repair subprocess for the method of FIG. 3;
FIG. 6 is a flowchart illustrating steps of an exemplary part finishing subprocess for the method of FIG. 3;
FIG. 7 is a block diagram of an exemplary machine learning module associated with the method of FIG. 3; and
FIG. 8 is a schematic representation of a computing device able to perform the steps of the method of FIG. 3.

### DETAILED DESCRIPTION

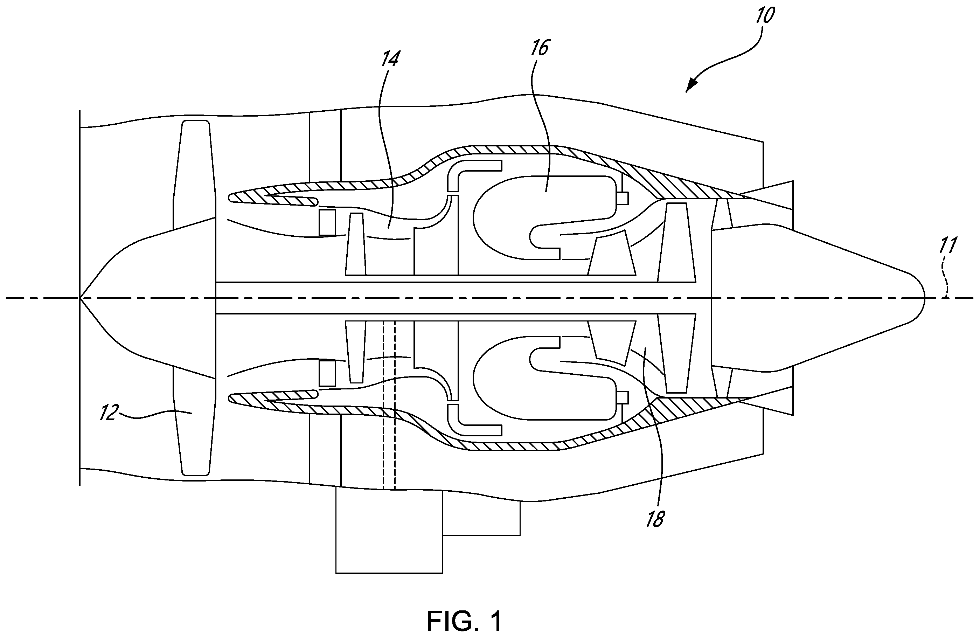

FIG. 1 illustrates a gas turbine engine 10 of a type preferably provided for use in subsonic flight, generally comprising in serial flow communication a fan 12 through which ambient air is propelled, a compressor section 14 for pressurizing the air, a combustor 16 in which the compressed air is mixed with fuel and ignited for generating an annular stream of hot combustion gases, and a turbine section 18 for extracting energy from the combustion gases. As indicated above, the present disclosure is directed to systems and methods for manufacturing a variety of different component types. The gas turbine engine 10 described above is provided as a non-limiting example of a device that includes different components that vary in complexity, and that can benefit from the present disclosure.

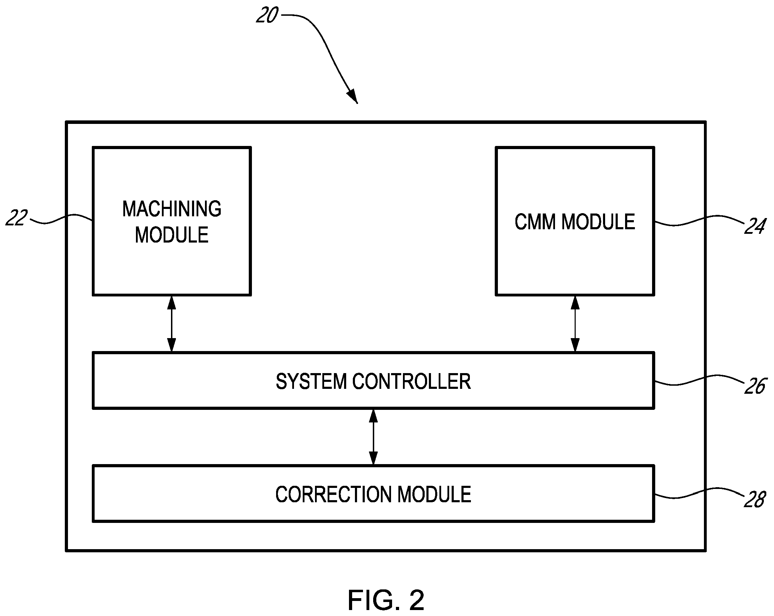

Referring to FIG. 2, embodiments of the present disclosure include a computer numerical control (CNC) machine tool 20 adapted to perform as described herein as part of a system or utilize such a CNC machine tool 20 within a present disclosure method. The present disclosure can be implemented with a variety of different type CNC machine tools including, but not limited to, milling machines, lathes, plasma cutters, electric discharge machines (EDMs), multi-spindle machines, wire EDMs, sinker EDMs, water jet cutters, punch presses, 3D printing equipment, and the like. In embodiments, the present disclosure provides particular utility for multi-axis machine tools. The depicted CNC machine tool 20, also referred to as a CNC machine tool assembly, includes a machining module 22, a coordinate measuring machine (CMM) module 24, and a system controller 26.

The CMM module 24 of the CNC machine tool 20 is configurable to operate as a contact inspection device (e.g., including a physical probe) or to operate as a non-contact inspection device (e.g., laser probing or scanning, etc.). Both contact type and non-contact type inspection devices are usable to identify surface points on a component in multiple axis coordinates. The present disclosure is not limited to including any particular CMM module 24 type. In an exemplary embodiment, the CMM module includes a 3D scanning system, also referred to as a 3D scanner, that is an optical system with at least one topometric system. For instance, in an embodiment, the 3D scanning system includes a topometric or blue light type scanner. Such a topometric sensor with blue light source projects the blue light on the targeted parts with a predefined structure (for example, black and white stripes, etc.). As the structured light projects on the part, the distortion of the light pattern captured by the camera(s) is used to create the 3D image of the objects (parts). Other scanner types are contemplated.

The system controller 26 is in communication with other system components such as the machining module 22 of the CNC machine tool 20, the CMM module 24, and the like. In embodiments, the system controller 26 is in communication with one or more of these modules to control the operation of the module and/or to receive signals from that module to perform the functions described herein. In embodiments, one or more of these modules themselves includes a controller that is in communication with the system controller 26. The system controller 26 (and other controllers) can include any type of computing device, computational circuit, processor(s), CPU, computer, or the like capable of executing a series of instructions that are stored in memory. The instructions include an operating system, and/or executable software modules such as program files, system data, buffers, drivers, utilities, and the like. The executable instructions are applicable to any functionality described herein to enable the system to accomplish the same algorithmically and/or coordination of system components. The system controller 26 includes or is in communication with one or more memory devices. The present disclosure is not limited to any particular type of memory device, and the memory device can store instructions and/or data in a non-transitory manner. Examples of such memory devices include read-only memory, random access memory, volatile memory, non-volatile memory, static memory, dynamic memory, flash memory, cache memory, and/or any device that stores digital information. In embodiments, the system controller 26 includes, or is in communication with, an input device that enables a user to enter data and/or instructions, and includes, or is in communication with, an output device configured, for example to display information (e.g., a visual display), or to transfer data, etc. Communications between the system controller 26 and other system components is done, for instance, via a hardwire connection or via a wireless connection.

Embodiments of the present disclosure include a system controller 26 that is configured to include or be in communication with a correction module 28. The correction module 28 is usable by the system controller 26 in combination with input from the CMM module 24 to evaluate component characteristics (e.g., dimensional geometry, etc.) and to determine corrective actions as can be required. The term "corrective actions" as used herein, and described in greater detail below, refers to one or more instructions that deviate from (e.g., add to, modify, etc.) and/or are independent of an initial set of stored instructions executable by the CNC machine tool 20 to machine the component at hand. As will be described herein, the correction module 28 includes stored inspection data representative of actual component measurements and instructions that correlate that inspection data to component measurements produced using the CMM module 24 of the CNC machine tool 20.

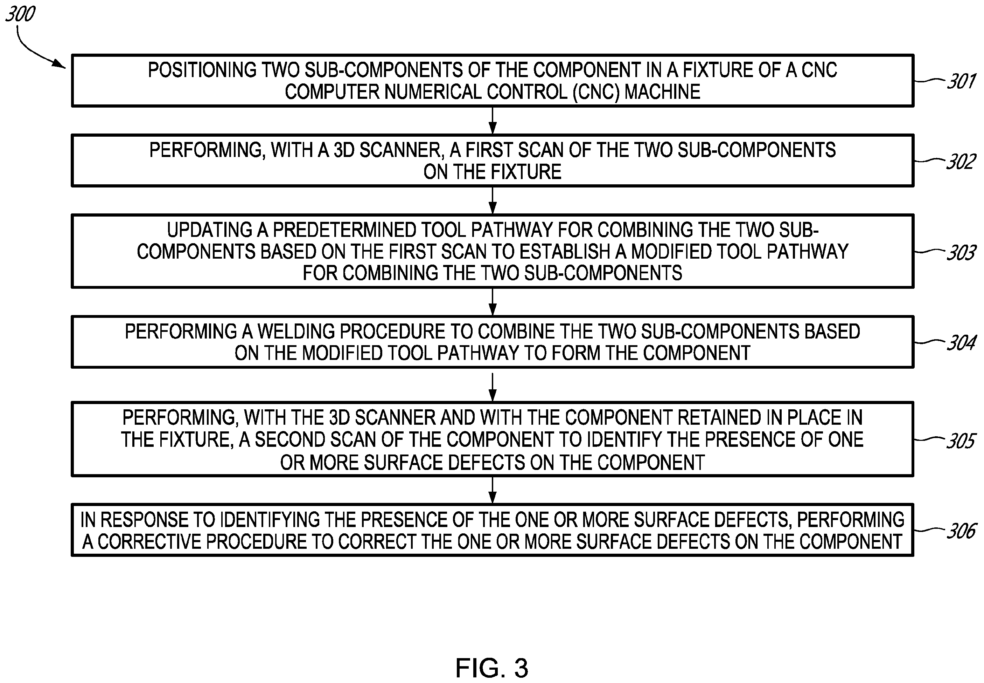

Referring now to FIG. 3, according to the present disclosure, there is provided a method 300 for manufacturing a component of an aircraft engine. For instance, in different embodiments, the method 300 is used to manufacture various cast components for the engine 10, for instance a vane ring for the compressor section 14 of the engine 10. It is understood that the steps of method 300 can be carried out by the above-described CNC machine tool 20. It is also understood that the components to be manufactured by way of method 300 include two or more sub-components to be combined by one or more manufacturing processes to form the component.

At step 301, the two sub-components of the component are positioned in a fixture of the CNC machine. In particular, the two sub-components are positioned relative to one another to assume the shape and profile of the component to be manufactured.

At step 302, performing, with a 3D scanner, a first scan of the two sub-components on the fixture is performed with a 3D scanner, for instance, a 3D scanner forming part of the CMM module 24. The scanning data is storable in memory associated with the system controller 26.

At step 303, a predetermined tool pathway for combining the two sub-components to is updated based on the first scan to establish a modified tool pathway for combining the two sub-components. As such, the tool pathway is modified based on the actual conditions of the sub-components, as well as their relative positions and orientations. In embodiments, the predetermined tool pathway is stored in the system controller 26 and updated, if necessary, in view of the scanning data obtained at step 303. For instance, while the predetermined tool pathway is determined based on the expected geometries of the sub-components, various factors (e.g., tolerances, different suppliers, component position and orientation on the assembly fixture) can lead to the actual geometries of the sub-components differing from the expected geometries. Step 304 therefore allows the CNC machine tool 20, and in particular the system controller 26, to update the predetermined tool pathway based on the actual shapes and dimensions of the sub-components.

At step 304, a welding procedure is performed to combine the two sub-components based on the modified tool pathway to form the component. For instance, the machining module 22 includes a welding tool to perform the combination.

At step 305, with the component retained in place in the fixture, a second scan of the component is performed with the 3D scanner to identify the presence of one or more surface defects on the component. For instance, the data associated with the surface defects is stored in memory associated with the system controller 26.

At step 306, in response to the identification of the one or more surface defects at step 305, a corrective procedure to correct the one or more surface defects on the component is performed based on the data collected at step 305. For instance, various tools of the machining module 22 are used to perform the corrective procedure, the extent of which is determinable by the correction module 28 in communication with the system controller 26.

In an embodiment, subsequent to the performing the corrective procedure at step 306, one or more automated finishing operations are performed on the component. For instance, one or more finishing tools in the machining module 22, for instance a polishing robot, are used to perform the finishing operation(s).

In an embodiment, the component remains on the fixture, without removal, between the step of mounting the two sub-components to the fixture (step 301) and the step of performing the corrective procedure to correct the one or more surface defects on the component (step 306).

In an embodiment, a third scan of the component is performed after the welding procedure at step 304 and the corrective procedure at step 306 are performed. For instance, the data associated with this third scan is stored in memory associated with the system controller 26. Based on the third scan, an indication of acceptability of the component is determined and outputted, for instance by the system controller 26, based on a predetermined acceptability criteria of the component. For instance, in embodiments, the acceptability of the component informs whether the component is to be accepted or rejected for use in the engine 10.

In an embodiment, subsequent to the determining and outputting an acceptability of the component based on the predetermined acceptability criteria of the component, data pertaining to the manufacturing of the component is transferred to a database of a machine learning model, as will be discussed in further detail below.

In an embodiment, the welding procedure performed at step 304 is a micro-welding procedure, also referred to as a micro laser welding procedure. Such micro-welding can, for instance, provide additional accuracy for intricate combination procedures. Additionally, welding parameters can be adjusted depending on the results of the 3D scanning, and therefore the welding process can be optimized based on the assembly analysis.

In an embodiment, the 3D scanner is a topometric scanner, and the performing the scan of the two sub-components on the fixture (step 302) includes acquiring coordinates of position markers on the two sub-components.

Other modifications and additions to the method 300 are contemplated.

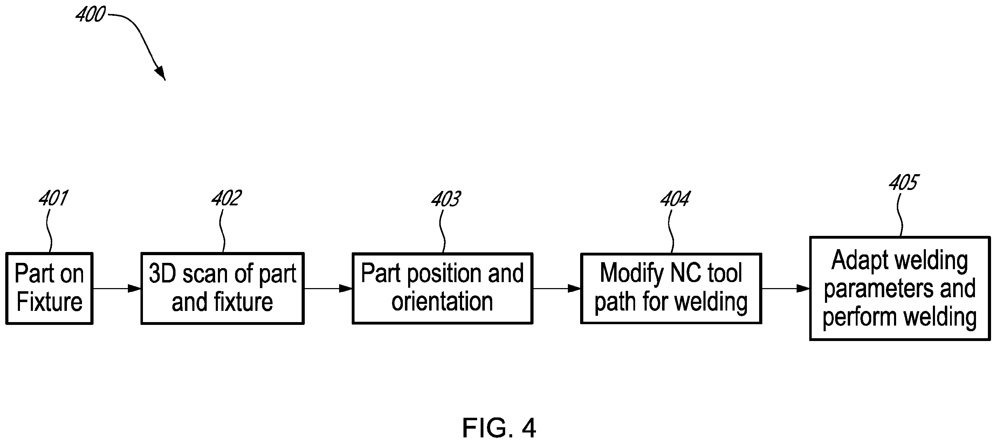

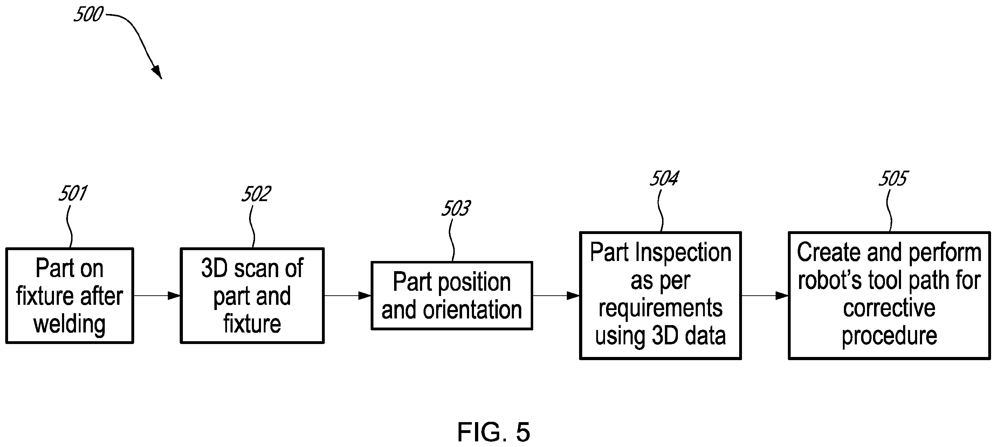

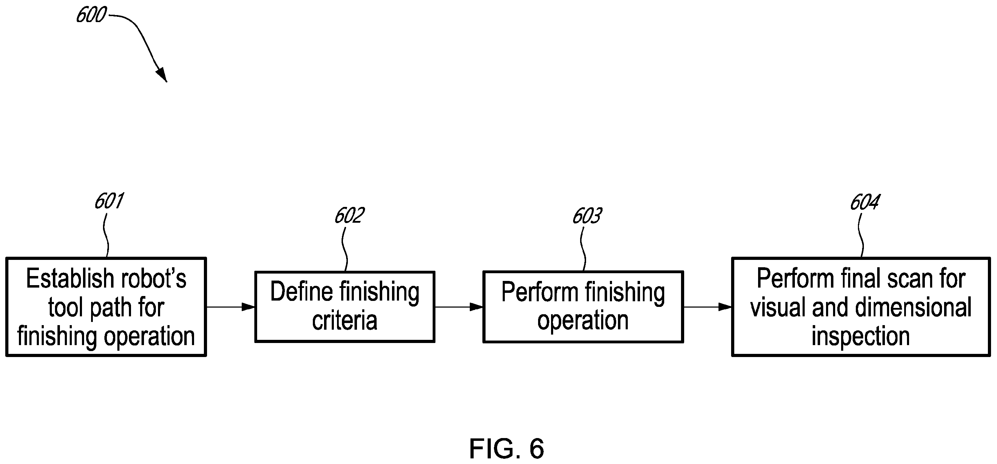

The above-described method 300, as well as the various embodiments of method 300 described above, can be grouped into three distinct sub-processes: an adaptive welding subprocess (see FIG. 4), a part analysis and repair subprocess (see FIG. 5), and a part finishing process (see FIG 6). It is understood that these subprocesses are performable by the CNC tooling machine 20. It is also understood that various implementations of the method 300 can be carried out by implementing one or more of these subprocesses in various combinations.

Referring now to FIG. 4, an adaptive welding subprocess 400 for the method 300 is depicted. At 401, the two sub-components (collectively referred to as a part) are mounted on the fixture of the CNC machine tool 20. At 402, a 3D scan of the part and fixture is taken, for instance, with the 3D scanner of the CMM module 24. At 403, the position and orientation of the part are obtained by way of the scan at 402. At 404, the numerical control (NC) predetermined tool path for the combination of the two sub-components is modified based on the position and orientation of the part. At 404, the original or baseline welding procedure is adapted by way of the predetermined tool path and performed on the two sub-components to form the component.

Referring now to FIG. 5, a part analysis and repair subprocess for the method 300 is depicted. At 501, the combined component or part remains in the fixture of the CNC machine tool 20 following the welding procedure. At 502, a 3D scan of the part and fixture is taken, for instance, with the 3D scanner of the CMM module 24. At 503, the position and orientation of the part are obtained by way of the scan at 502. At 504 and 505, the part is inspected, as required by aircraft manufacturing procedures. For instance, the inspection includes a visual inspection and a dimensional inspection using the data obtained by way of the scan at 502 and the data extracted at 503.

Referring now to FIG. 6, a part finishing process 600 for the method 300 is depicted. As noted above, in some embodiments of the method 300, the part finishing process is omitted. At 601, a robot's tool path for a finishing operation is established, for instance by the system controller 26. At 602, the finishing criteria for the component is defined. At 603, the finishing operation is performed, for instance by one or more tools in the machining module 22. At 604, a final scan, for instance with the 3D scanner of the CMM machine, is performed for visual and dimensional inspection of the component. It is understood that in some embodiments where the finishing step is omitted, the final inspection at 604 is carried out immediately following the part analysis and repair process at 500.

According to the present disclosure, there is provided a system for manufacturing a component of an aircraft engine 10. The system includes a CNC machine tool 20 having a fixture for retaining the component, in particular the two sub-components of the component to be machined. A machining module 22 is selectively controllable to machine the component. A CMM module 24 is selectively controllable to perform various 3D scans of the component. A controller, for instance system controller of the CNC machine tool 20, is in communication with the various modules of the CNC machine tool 20. The system further includes non-transitory memory storing instructions, which instructions when executed cause the system controller to perform the above-described method 300.

In particular, the machining module 22 is selectively controllable to perform a welding procedure to produce the component from the two sub-components based on a tool pathway for the welding procedure, and a correction procedure to correct one or more identified defects of the component. In addition, the CMM module is selectively controllable to perform a first scan of the two sub-components to modify a predetermined tool pathway for the welding procedure to establish an actual tool pathway for the welding procedure. The CMM module is further selectively controllable to perform a second scan of the component, subsequent to the welding of the two sub-components, to identify the one or more identified defects of the component to be corrected. The CMM module is further selectively controllable to perform a third scan of the component to inform a judgment of an acceptability of the component based on a predetermined acceptability criteria of the component.

The above-described system can thus be referred to as an adaptive welding system, the system is provided with predetermined instructions for an upcoming welding procedure which can be modified based on data obtained from various scans performed on the actual subcomponents to be welded.

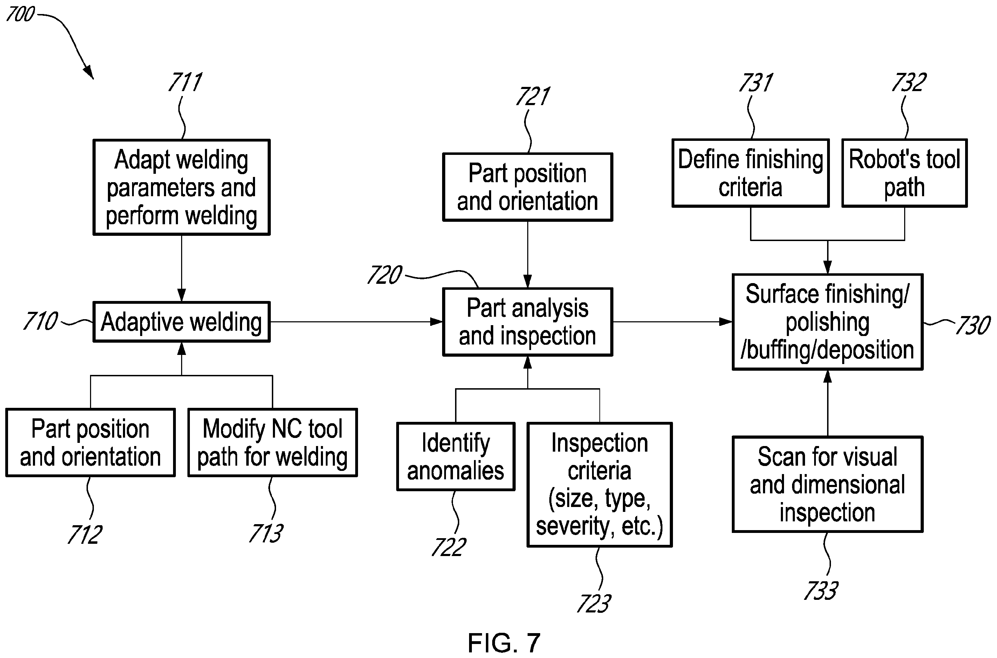

Referring now to FIG. 7, there is shown at 700 an exemplary machine learning model for controlling the various operations performed by the above-described system. In embodiments, the machine learning model is created and matured to optimize the above-describes processes and allow for early detection of drifts in process control parameters. In embodiments, the machine learning model 700 includes a database containing data pertaining to, for instance, welding tool path trends, types and sizes of surface anomalies, and robot tool path trends. The collection of such data can allow for better control of the various operations performed by the above-described system as benchmarks are created to inform future manufacturing processes.

Still referring to FIG. 7, the depicted machine learning model 700 is adapted to store data pertaining to the adaptive welding process at 710 (see FIG. 4), part analysis and inspection at 720 (see FIG. 5), and the surface finishing process at 730 (see FIG. 6). In particular, with regards to the adaptive welding process 710, data is collected pertaining to, for instance, the adapted welding parameters and welding performance at 711, the position and orientation of the scanned component at 712, and modified NC tool paths for the welding procedures at 713. With regards to the part analysis and inspection at 720, data is collected pertaining to, for instance, the position and orientation of the scanned component at 721, identified anomalies (or surface defects) at 722, and various inspection criteria at 723. With regards to the surface finishing process at 730, data is collected pertaining to, for instance, defined finishing criteria at 731, tool paths of the robot at 732, and scanned data for visual and dimensional inspection at 733. In other embodiments, other data that informs future manufacturing procedures can further be stored and interpreted in the machine learning module 700.

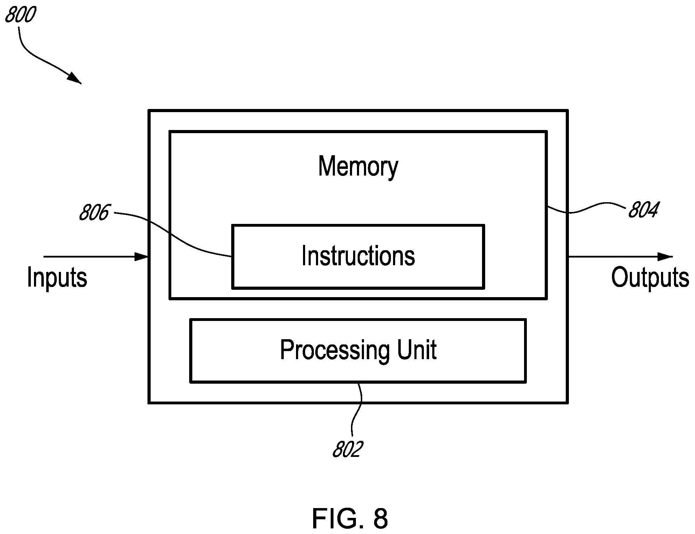

With reference to FIG. 8, an example of a computing device 800, for instance system controller 26, is illustrated. For simplicity only one computing device 800 is shown but the system may include more computing devices 800 operable to exchange data. The computing devices 800 may be the same or different types of devices. The computing device 800 comprises a processing unit 802 and a memory 804 which has stored therein computer-executable instructions 806. The processing unit 802 may comprise any suitable devices configured to implement the method 300 such that instructions 806, when executed by the computing device 800 or other programmable apparatus, may cause the functions/acts/steps performed as part of the method 300 as described herein to be executed. The processing unit 802 may comprise, for example, any type of general-purpose microprocessor or microcontroller, a digital signal processing (DSP) processor, a central processing unit (CPU), an integrated circuit, a field programmable gate array (FPGA), a reconfigurable processor, other suitably programmed or programmable logic circuits, or any combination thereof.

The memory 804 may comprise any suitable known or other machine-readable storage medium. The memory 804 may comprise non-transitory computer readable storage medium, for example, but not limited to, an electronic, magnetic, optical, electromagnetic, infrared, or semiconductor system, apparatus, or device, or any suitable combination of the foregoing. The memory 804 may include a suitable combination of any type of computer memory that is located either internally or externally to device, for example random-access memory (RAM), read-only memory (ROM), compact disc read-only memory (CDROM), electro-optical memory, magnetooptical memory, erasable programmable read-only memory (EPROM), and electrically-erasable programmable read-only memory (EEPROM), Ferroelectric RAM (FRAM) or the like. Memory 804 may comprise any storage means (e.g., devices) suitable for retrievably storing machine-readable instructions 806 executable by processing unit 802.

The methods and systems for evaluating an aircraft engine component for compliance with flow requirements described herein may be implemented in a high level procedural or object oriented programming or scripting language, or a combination thereof, to communicate with or assist in the operation of a computer system, for example the computing device 800. Alternatively, the methods and systems for evaluating an aircraft engine component for compliance with flow requirements may be implemented in assembly or machine language. The language may be a compiled or interpreted language. Program code for implementing the methods and systems for evaluating an aircraft engine component for compliance with flow requirements may be stored on a storage media or a device, for example a ROM, a magnetic disk, an optical disc, a flash drive, or any other suitable storage media or device. The program code may be readable by a general or special-purpose programmable computer for configuring and operating the computer when the storage media or device is read by the computer to perform the procedures described herein. Embodiments of the methods and systems for evaluating an aircraft engine component for compliance with flow requirements may also be considered to be implemented by way of a non-transitory computer-readable storage medium having a computer program stored thereon. The computer program may comprise computer-readable instructions which cause a computer, or more specifically the processing unit 802 of the computing device 800, to operate in a specific and predefined manner to perform the functions described herein, for example those described in the method 300.

Computer-executable instructions may be in many forms, including program modules, executed by one or more computers or other devices. Generally, program modules include routines, programs, objects, components, data structures, etc., that perform particular tasks or implement particular abstract data types. Typically the functionality of the program modules may be combined or distributed as desired in various embodiments.

The embodiments described herein are implemented by physical computer hardware, including computing devices, servers, receivers, transmitters, processors, memory, displays, and networks. The embodiments described herein provide useful physical machines and particularly configured computer hardware arrangements. The embodiments described herein are directed to electronic machines and methods implemented by electronic machines adapted for processing and transforming electromagnetic signals which represent various types of information. The embodiments described herein pervasively and integrally relate to machines, and their uses; and the embodiments described herein have no meaning or practical applicability outside their use with computer hardware, machines, and various hardware components. Substituting the physical hardware particularly configured to implement various acts for non-physical hardware, using mental steps for example, may substantially affect the way the embodiments work. Such computer hardware limitations are clearly essential elements of the embodiments described herein, and they cannot be omitted or substituted for mental means without having a material effect on the operation and structure of the embodiments described herein. The computer hardware is essential to implement the various embodiments described herein and is not merely used to perform steps expeditiously and in an efficient manner.

It is noted that various connections are set forth between elements in the preceding description and in the drawings. It is noted that these connections are general and, unless specified otherwise, may be direct or indirect and that this specification is not intended to be limiting in this respect. A coupling between two or more entities may refer to a direct connection or an indirect connection. An indirect connection may incorporate one or more intervening entities. The term "connected" or "coupled to" may therefore include both direct coupling (in which two elements that are coupled to each other contact each other) and indirect coupling (in which at least one additional element is located between the two elements).

It is further noted that various method or process steps for embodiments of the present disclosure are described in the preceding description and drawings. The description may present the method and/or process steps as a particular sequence. However, to the extent that the method or process does not rely on the particular order of steps set forth herein, the method or process should not be limited to the particular sequence of steps described. As one of ordinary skill in the art would appreciate, other sequences of steps may be possible. Therefore, the particular order of the steps set forth in the description should not be construed as a limitation.

As used herein, the terms "comprises", "comprising", or any other variation thereof, are intended to cover a non-exclusive inclusion, such that a process, method, article, or apparatus that comprises a list of elements does not include only those elements but may include other elements not expressly listed or inherent to such process, method, article, or apparatus.

While various aspects of the present disclosure have been disclosed, it will be apparent to those of ordinary skill in the art that many more embodiments and implementations are possible within the scope of the present disclosure. For example, the present disclosure as described herein includes several aspects and embodiments that include particular features. Although these particular features may be described individually, it is within the scope of the present disclosure that some or all of these features may be combined with any one of the aspects and remain within the scope of the present disclosure. References to "various embodiments," "one embodiment," "an embodiment," "an example embodiment," etc., indicate that the embodiment described may include a particular feature, structure, or characteristic, but every embodiment may not necessarily include the particular feature, structure, or characteristic. Moreover, such phrases are not necessarily referring to the same embodiment. The use of the indefinite article "a" as used herein with reference to a particular element is intended to encompass "one or more" such elements, and similarly the use of the definite article "the" in reference to a particular element is not intended to exclude the possibility that multiple of such elements may be present.

The embodiments described in this document provide non-limiting examples of possible implementations of the present technology. Upon review of the present disclosure, a person of ordinary skill in the art will recognize that changes may be made to the embodiments described herein without departing from the scope of the present technology. Yet further modifications could be implemented by a person of ordinary skill in the art in view of the present disclosure, which modifications would be within the scope of the present technology.

## Claims

1. A method (300) for manufacturing a component of an aircraft engine (10), comprising:
positioning two sub-components of the component in a fixture of a computer numerical control (CNC) machine;
performing, with a 3D scanner, a first scan of the two sub-components on the fixture;
updating a predetermined tool pathway for combining the two sub-components based on the first scan to establish a modified tool pathway for combining the two sub-components;
performing a welding procedure to combine the two sub-components based on the modified tool pathway to form the component;
performing, with the 3D scanner and with the component retained in place in the fixture, a second scan of the component to identify the presence of one or more surface defects on the component; and
in response to identifying the presence of the one or more surface defects, performing a corrective procedure to correct the one or more surface defects on the component.

2. The method (300) of claim 1, wherein the component remains on the fixture, without removal, between the step of mounting the two sub-components to the fixture of the CNC machine and the step of performing the corrective procedure to correct the one or more surface defects on the component.

3. The method (300) of claim 1 or 2, further comprising, subsequent to the performing the corrective procedure, performing one or more finishing operations on the component.

4. The method (300) of any preceding claim, wherein the performing the welding procedure to combine the two sub-components includes performing a micro-welding procedure.

5. The method (300) of any preceding claim, wherein the 3D scanner is a topometric scanner and the performing the scan of the two sub-components on the fixture includes acquiring coordinates of position markers on the two sub-components.

6. The method (300) of any preceding claim, further comprising performing a third scan of the component, and based on the third scan, determining and outputting an indication of acceptability of the component based on a predetermined acceptability criteria of the component.

7. The method (300) of claim 6, further comprising, subsequent to the determining and outputting an acceptability of the component based on the predetermined acceptability criteria of the component, transferring data pertaining to the manufacturing of the component to a database of a machine learning model, and optionally transferring data pertaining to one or more of trends in the welding procedure of the component and trends in the one or more surface defects on the component.

8. A system for manufacturing a component of an aircraft engine (10), comprising:
a computer numerical control (CNC) machine tool (20) having a fixture for retaining the component, a machining module (22) selectively controllable to machine the component, and a coordinate measuring machine (CMM) module (24) selectively controllable to perform a 3D scan of the component;
a controller (26;800) in communication with the CNC machine tool (20), the controller (26) including a processing unit (802); and
non-transitory memory (804) communicatively coupled to the processing unit (802) and comprising computer-readable program instructions (806) executable by the processing unit (802) for:
positioning two sub-components of the component in a fixture of a CNC computer numerical control (CNC) machine;
performing, with a 3D scanner, a first scan of the two sub-components on the fixture;
updating a predetermined tool pathway for combining the two sub-components based on the first scan to establish a modified tool pathway for combining the two sub-components;
performing a welding procedure to combine the two sub-components based on the modified tool pathway to form the component;
performing, with the 3D scanner and with the component retained in place in the fixture, a second scan of the component to identify the presence of one or more surface defects on the component; and
in response to identifying the presence of the one or more surface defects, performing a corrective procedure to correct the one or more surface defects on the component.

9. The system of claim 8, configured such that the component remains on the fixture, without removal, between the step of mounting the two sub-components to the fixture of the CNC machine and the step of performing a corrective procedure to correct the one or more surface defects on the component.

10. The system of claim 8 or 9, further comprising a finishing tool, and wherein the instructions are further executable by the processing unit (802) for, subsequent to the performing the corrective procedure, performing one or more finishing operations on the component.

11. The system of any of claims 8 to 10, wherein the performing the welding procedure to combine the two sub-components includes performing a micro-welding procedure.

12. The system of any of claims 8 to 11, wherein the 3D scanner is a topometric scanner and the performing the scan of the two sub-components on the fixture includes acquiring coordinates of position markers on the two sub-components.

13. The system of any of claims 8 to 12, wherein the non-transitory memory (804) communicatively coupled to the processing unit (802) and comprising computer-readable program instructions (806) executable by the processing unit (802) for:
performing a third scan of the component; and
based on the third scan, determining and outputting an indication of acceptability of the component based on a predetermined acceptability criteria of the component.

14. The system of claim 13, wherein the instructions (806) are further executable by the processing unit (802) for, subsequent to the determining and outputting an acceptability of the component based on the predetermined acceptability criteria of the component, transferring data pertaining to the manufacturing of the component to a database of a machine learning model, and optionally wherein transferring data pertaining to the manufacturing of the component to the database of the machine learning model includes transferring data pertaining to one or more of trends in the welding procedure of the component and trends in the one or more surface defects on the component.

15. A computer numerical control (CNC) machine tool assembly for manufacturing a component of an aircraft engine (10), comprising:
a fixture for receiving two sub-components of the component;
a machining module (22) selectively controllable to perform:
a welding procedure to produce the component from the two sub-components based on a tool pathway for the welding procedure; and
a correction procedure to correct one or more identified defects of the component; and
a coordinate measuring machine (CMM) module (24) selectively controllable to perform:
a first scan of the two sub-components in the fixture to modify a predetermined tool pathway for the welding procedure to establish an actual tool pathway for the welding procedure;
a second scan of the component, subsequent to the welding of the two sub-components, to identify the one or more identified defects of the component to be corrected; and
a third scan of the component to inform a judgment of an acceptability of the component based on a predetermined acceptability criteria of the component.
